# EUROPÄISCHE PATENTSCHRIFT

(11) **EP 3 786 652 B1**
(45) Veröffentlichungstag und Bekanntmachung des Hinweises auf die Patenterteilung: **06.12.2023**
(21) Anmeldenummer: 19306045.6
(22) Anmeldetag: 29.08.2019
(51) Int. Cl.: G01R 31/08, G01R 19/165, G01R 19/25

(54) **VERFAHREN UND SYSTEM ZUR LOKALISIERUNG EINES KURZSCHLUSSES ZWISCHEN EINEM LEITER UND EINEM DIESEN UMGEBENDEN ELEKTRISCH LEITENDEN SCHIRM**
METHOD AND SYSTEM FOR LOCATING A SHORT-CIRCUIT BETWEEN A CONDUCTOR AND AN ELECTRICALLY CONDUCTIVE SCREEN SURROUNDING SAID CONDUCTOR
PROCÉDÉ ET SYSTÈME DE LOCALISATION D'UN COURT-CIRCUIT ENTRE UN CONDUCTEUR ET UN BLINDAGE ÉLECTROCONDUCTEUR ENTOURANT LEDIT CONDUCTEUR

(43) Veröffentlichungstag der Anmeldung: 03.03.2021
(73) Patentinhaber: Nexans, 92400 Courbevoie (FR)
(72) Erfinder: FROHNE, Christian, 30657 HANNOVER (DE); GAULER, Volker, 30900 Wedemark (DE); NOROUZI, Younes, 30165 HANNOVER (DE); DUBOIS, David, 62890 CLERQUES (FR)
(74) Vertreter: Ipsilon

(56) Entgegenhaltungen:
- CN-A- 109 031 021
- CN-A- 109 738 763
- DE-A1- 4 416 966
- JP-A- 2015 230 289

## Beschreibung

### Gebiet

Die Erfindung betrifft ein System und ein Verfahren zur Lokalisierung von Kurzschlüssen zwischen einem elektrischen Leiter eines Hochspannungs-Energiekabels und einem den elektrischen Leiter umgebenden elektrisch leitenden Schirm. Die Erfindung betrifft außerdem eine Übertragungsstrecke für elektrische Energie mit einem erfindungsgemäßen System, sowie eine Messeinrichtung zur Verwendung in dem erfindungsgemäßen System.

### Hintergrund

Hochspannungs-Energiekabel werden in der Regel für die Übertragung von elektrischer Energie dort eingesetzt, wo Freileitungen oder gasisolierte Rohrleiter nicht genutzt werden können. In großen Längen werden sie bevorzugt bei Seekabeln und Hochspannungs-GleichstromÜbertragungsstrecken genutzt. Hochspannungs-Energiekabel umfassen einen spannungsführenden elektrischen Leiter, der den Strom trägt, und der von einer elektrischen Isolierung umgeben ist. Die elektrische Isolierung ist wiederum von einem elektrisch leitenden Schirm umgeben, welcher üblicherweise an beiden Enden und ggf. entlang der Strecke ein- oder mehrfach mit Erde verbunden ist. Der elektrisch leitende Schirm kann bspw. ein metallischer Schirm sein, der außerdem zusätzlich einen mechanischen Schutz der Isolierung bieten kann.

Hochspannungs-Energiekabel können nur bis zu einer bestimmten Höchstlänge in einem Stück transportiert werden, die unter anderem durch das Gewicht und den Durchmesser einer das Kabel aufnehmenden Kabeltrommel oder Kabelrolle bestimmt wird. Maximales Gewicht und Durchmesser hängen von den zur Verfügung stehenden Transportmitteln und den zu nutzenden Transportwegen ab. Um Energiekabel über größere Entfernungen zu verlegen ist es daher notwendig, mehrere Energiekabel miteinander leitend zu verbinden. Hierzu kommen spezielle Verbindungsgarnituren zum Einsatz, die die Leiter und die elektrisch leitenden Schirme zweier Kabelsegmente einer Übertragungsstrecke für elektrische Energie miteinander verbinden. Um das entstehen größerer Spannungen auf dem elektrisch leitenden Schirm im Betrieb zu verhindern können die Schirme an den jeweiligen Verbindungsstellen nicht nur miteinander verbunden sein, sondern auch mit Erde verbunden sein.

Die elektrische Isolierung zwischen dem elektrischen Leiter und dem elektrisch leitenden Schirm kann aus den unterschiedlichsten Gründen versagen, etwa bei einer zu hohen Spannung, durch externe mechanische Beschädigung oder durch sogenanntes "electrical treeing". Electrical treeing beschreibt eine einem Durchbruch einer festen Isolierschicht vorausgehende Schädigung der Isolierung aufgrund von Teilentladungen, die langsam durch die Isolierschicht fortschreitet und dabei Pfade bildet, die den Ästen eines Baumes ähneln. Electrical treeing tritt bevorzugt an Stellen einer Isolierung auf, die Verunreinigungen oder Blasen im Isoliermaterial aufweisen, oder die mechanischen Belastungen ausgesetzt waren bzw. sind.

Ein Versagen der elektrischen Isolierung äußert sich als mehr oder weniger niederohmiger Kurzschluss zwischen dem elektrischen Leiter und dem elektrisch leitenden Schirm. Da der Schirm an den Enden der Übertragungsstrecke vergleichsweise niederohmig mit Erde verbunden ist, fließt ein Strom von dem Leiter über den Kurzschluss zu dem Schirm und über den Schirm gegen Erde. Der Strom fließt dabei von dem Ort des Kurzschlusses zu den beiden geerdeten Enden des Schirms, wobei der Strom zu jeder Seite des Kurzschlusses abhängig von der Impedanz der Kabelstrecke ist.

Der Zeitpunkt des Versagens der elektrischen Isolierung und vor allem der Ort des Versagens können nicht sicher vorhergesagt werden. Es existieren zwar Verfahren zur Überprüfung des Zustands der Kabelstrecke, z.B. das Messen des Verlustfaktors oder der Teilentladungen, jedoch erfordern diese meist eine Außerbetriebnahme der Kabelstrecke, d.h., die Kabelstrecke kann für die Zeit der Überprüfung keine Energie Übertragen. Außerdem ist auch bei den bekannten Verfahren keine sehr genaue Lokalisierung einer beginnenden oder fortgeschrittenen Schädigung der Isolierung möglich.

Die Druckschrift CN 109 738 763 offenbart ein Verfahren zur Bestimmung eines Fehlerortes in einem Mittelspannungskabel. Dazu wird an beiden Enden des Mittelspannungskabels jeweils der Strom zwischen Schirm und Erde über einen Stromtransformator geleitet. Ein an einem Ausgang des Stromtransformators anliegendes Signal wird einer Auslöseschaltung zugeführt, die bei Überschreiten eines Schwellwerts die Messung des Stroms in einem Messgerät auslöst. Die Bestimmung des Fehlerorts erfolgt durch eine "wavelet packet multi-scale" Analyse, bei der das Signal in seine Frequenzanteile aufgespalten wird. Durch die Analyse können vor allem Verzerrungen eines Signals bei großen Distanzen zum Fehlerort korrigiert werden, welche durch von Eigenschaften des Kabels und der Frequenz abhängige Ausbreitungsgeschwindigkeiten und Dämpfung hervorgerufen werden.

Die Druckschrift JP 2015 230289 A offenbart ein Verfahren zur Bestimmung der Verschlechterung einer Isolierung eines Wechselspannungs-Energiekabels während des Betriebs. Dazu werden Teilentladungen während des Betriebs erfasst, welche sich mit der Frequenz der Wechselspannung insbesondere an den Spannungssitzen wiederholen. Die Messung erfolgt jeweils an den Enden des Kabels.

Die Druckschrift CN 109 031 021 A offenbart ein Verfahren zur Bestimmung eines Fehlerorts in einem Kabel, bei dem sich von dem Fehlerort als Welle ausbreitende Stromsignale auf dem Kabelschirm an einem oder beiden Kabelenden erfasst werden. Das oder die Stromsignale werden jeweils einer Time-Domain-Inversion unterzogen, und die resultierenden Time-Domain-Inversion Stromsignale werden in eine Frequenz-Domain konvertiert. Anhand der Frequenzen, bei denen jeweils das Energiemaximum liegt, und der Kabelimpedanz wird von jeder Seite aus der Fehlerort ermittelt. Die Analyse in der Frequenz-Domain verringert den Einfluss der unterschiedlichen Ausbreitungsgeschwindigkeiten und Dämpfungen der jeweiligen Frequenzen, welche von Eigenschaften des Kabels abhängen.

Die Druckschrift DE 44 16 966 A1 offenbart eine Schaltungsanordnung zur Ermittlung eines Erdschlusses in einem Energieübertragungskabel, bei der an beiden Kabelenden jeweils eine Detektoranordnung vorgesehen ist, die auf einen über die Abschirmung gegen Erde fließenden Strom anspricht. Der Fehlerort wird dabei über die zueinander ins Verhältnis gesetzten Stromstärken bestimmt.

Wenn ein Durchschlag der Isolierung aufgetreten ist muss die defekte Stelle des Kabels repariert oder ausgetauscht werden. Dazu ist es notwendig zu wissen, wo der genaue Ort des Fehlers liegt, d.h. in welcher Entfernung zu einem Ende des Kabels oder in welchem Segment eines Kabels, weil die Kabel in der Regel im Erdboden vergraben sind, und ein Ausgraben des Kabels über die gesamte Länge sich schon aus Kostengründen verbietet.

Hiervon ausgehend hat die vorliegende Erfindung die Aufgabe, ein Verfahren zur Lokalisierung von Kurzschlüssen zwischen dem Leiter und dem Schirm bzw. von Durchschlägen in der Isolierung von Kabeln von Hochspannungs-Gleichstromübertragungsstrecken zu schaffen, das im Betrieb während der Fehlerentstehung den Fehler lokalisiert und eine hohe Genauigkeit bietet. Eine weitere Aufgabe der Erfindung ist es, ein Verfahren bereitzustellen, das die Genauigkeit von Offline-Fehlerortungsverfahren verbessert, bei dem nach Auftreten des Fehlers und nach Trennung der Kabelstrecke vom Netz Fremdspannungen zur Fehlerortung eingespeist werden.

### Zusammenfassung der Erfindung

Zur Lösung dieser Aufgabe schlägt die Erfindung nach einem ersten Aspekt ein Verfahren vor, welches das zeitlich verzögerte Auftreten von Effekten eines Kurzschlusses in unterschiedlichen Entfernungen vom Ort des Kurzschlusses zur Lokalisierung eines Kurzschlusses zwischen einem Leiter und einem diesen umgebenden elektrisch leitenden Schirm eines Hochspannungskabels nutzt. Nach einem zweiten Aspekt schlägt die Erfindung eine Messeinrichtung zur Erfassung eines in dem elektrisch leitenden Schirm eines Hochspannungskabels und/oder eines in einer den elektrisch leitenden Schirm und Erde verbindenden Erdungsleitung fließenden elektrischen Stroms und des Zeitpunkts dessen Auftretens vor, welche zur Anwendung in dem Verfahren gemäß dem ersten Aspekt eingerichtet ist. Nach einem dritten Aspekt schlägt die Erfindung ein System zur Lokalisierung eines Kurzschlusses zwischen einem Leiter und einem diesen umgebenden elektrisch leitenden Schirm eines Hochspannungskabels mit zwei oder mehr Messeinrichtungen gemäß dem zweiten Aspekt vor. Schließlich schlägt die Erfindung nach einem vierten Aspekt eine Übertragungsstrecke für elektrische Energie mit einem System zur Lokalisierung eines Kurzschlusses gemäß dem dritten Aspekt vor.

Nach einem weiteren Aspekt können die vorstehend genannten Aspekte nicht nur vorteilhaft eingesetzt werden, wenn die auswertbaren Signale vom Kurzschluss selbst verursacht werden, sondern auch, wenn nach einem Fehler im Kabel ein am Kabelende fremd eingespeistes Signal das Kabel entlangläuft und erfindungsgemäß ausgewertet wird.

Ein Verfahren nach dem ersten Aspekt zur Lokalisierung eines Kurzschlusses zwischen einem Leiter und einem diesen umgebenden elektrisch leitenden Schirm eines Hochspannungskabels umfasst das Bereitstellen mindestens zweier jeweils in bekanntem Abstand voneinander bzw. von den Enden des Hochspannungskabels an dem Hochspannungskabel angeordneter Messeinrichtungen. Die Messeinrichtungen weisen miteinander synchronisierte Zeitgeber auf, sowie eine Messvorrichtung zur Erfassung eines in dem elektrisch leitenden Schirm und/oder eines in einer den elektrisch leitenden Schirm und Erde verbindenden Erdungsleitung fließenden Stroms. Das Verfahren umfasst außerdem das Übertragen, zyklisch für aneinander angrenzende Zeitabschnitte oder kontinuierlich, von Paaren aus Strommesswerten und dazugehörigen Werten des Zeitgebers von der oder den Messvorrichtungen an eine Analyseeinheit.

Die Paare aus Strommesswerten und dazugehörigen Werten des Zeitgebers sind zweckmäßigerweise mit einer hohen Abtastrate erfasst, beispielsweise alle 0,5 µs oder in noch kürzeren zeitlichen Abständen.

Eine kontinuierliche Übertragung an die Analyseeinheit setzt eine ausreichend schnelle Datenverbindung voraus. In einer Ausführungsform ist die Analyseeinheit daher Teil der Messeinrichtung, sodass schnelle interne Verbindungen zwischen den Einheiten genutzt werden können.

Eine zyklische Übertragung von Paaren von Strommesswerten und dazugehörigen Werten des Zeitgebers kann bspw. dann vorteilhaft sein, wenn die Analyseeinheit nicht Teil der Messeinrichtung ist, sondern von mehreren Messeinrichtungen gemeinsam genutzt wird. Zumindest für die zyklische Übertragung können die Paare von Strommesswerten und dazugehörigen Werte des Zeitgebers zwischengespeichert werden, bevor sie gesammelt an die Analyseeinheit übertragen werden. Um die zu übertragene Datenmenge klein zu halten können Datenkompressionsverfahren genutzt werden. In der Analyseeinheit können die zyklisch empfangenen Daten wieder zu einer kontinuierlichen Messreihe zusammengesetzt werden, welche dann analysiert wird.

Die Analyseeinheit führt einer Berechnungseinheit zumindest den Wert des Zeitgebers zu, der nach dem Auftreten eines einen Schwellwert überschreitenden Stroms und/oder eines bestimmte Vorgaben erfüllenden Stromverlaufs über die Zeit als der Zeitpunkt bestimmt wurde, an dem Effekte eines Kurzschlusses zwischen dem Leiter und dem diesen umgebenden elektrisch leitenden Schirm erstmals auftraten, sowie den Ort der Messung. Wenn eine gemeinsam genutzte Analyseeinheit für mehrere Messeinrichtungen vorgesehen ist führt die Analyseeinheit der Berechnungseinheit entsprechend die Werte der synchronisierten Zeitgeber der mehreren Messeinrichtungen und deren Orte zu. Der Ort der Messung muss keine geographische Angabe sein, es genügt die Angabe einer Entfernung des Messorts zu einem Referenzpunkt an dem Hochspannungskabel.

Die Schwellenwerte können für jede Messstelle individuell festgelegt sein, beispielsweise abhängig von der Impedanz der Erdungsleitung an der betreffenden Messstelle.

Die Analyseeinheit kann die Paare von Strommesswerten und dazugehörigen Werten des Zeitgebers mittels einer künstlichen Intelligenz oder mittels Verfahren zum maschinellen Lernen auswerten, welche typische, bei Kurzschlüssen zwischen dem Leiter und dem elektrisch leitenden Schirm auftretende Stromverläufe über die Zeit erkennen. Hierzu kann eine Vielzahl typischer Referenz-Stromverläufe über die Zeit bereitgestellt werden. Die Analyseeinheit ermittelt oder bestimmt daraus einen Zeitpunkt, an dem Effekte eines Kurzschlusses zwischen Leiter und elektrisch leitendem Schirm an der jeweiligen Messstelle auftraten. Bei einer einfacheren Ausgestaltung kann die Analyseeinheit auch einen einfachen Mustervergleich zwischen der Vielzahl von Referenz-Stromverläufen über die Zeit durchführen und daraus den Zeitpunkt ermitteln oder bestimmen, an dem erste Effekte eines Kurzschlusses zwischen Leiter und elektrisch leitendem Schirm an der jeweiligen Messstelle auftraten. Die Referenz-Stromverläufe über die Zeit können durch Simulationen ermittelt werden. Dabei ist es denkbar, für jede Messeinrichtung individuelle Referenz-Stromverläufe über die Zeit bereitzustellen, um so beispielsweise Eigenschaften des Kabels und der Erdungsleitung zu berücksichtigen.

Die Analyseeinheit kann bspw. einen Ringspeicher aufweisen, der eine Reihe von mit hoher Abtastrate erfasste Paaren von Strommesswerten und Werten des zugehörigen Zeitgebers für eine Analyse speichert, bspw. um den Verlauf des Stroms für die Analyse abbilden zu können. Solange kein Indiz für einen Kurzschluss an irgendeiner Stelle der Übertragungsstrecke vorliegt, bspw. kein Schwellenwert überschritten wurde, werden neue Paare von Messwerten in den Ringspeicher eingespeichert, und die jeweils ältesten entfernt. Sobald ein Indiz für einen Kurzschluss vorliegt kann noch eine bestimmte Anzahl von weiteren Messwerten in dem Ringspeicher gespeichert werden, bis eine hinreichende Zahl von Paaren von Messwerten vorliegt, die den Stromverlauf zeitlich vor und nach dem Kurzschluss abbilden. Diese Daten können dann näher analysiert werden, um den Zeitpunkt des ersten Auftretens von Effekten des Kurzschlusses am Messort zu bestimmen. Der Zeitpunkt des ersten Auftretens von Effekten kann wegen einer zur Vermeidung von Fehlalarmen nötigen Ansprechschwelle auch vor dem Zeitpunkt des Überschreitens des Schwellenwerts liegen kann, der die Analyse auslöst. Die zeitlichen Stromverläufe um den Fehlerzeitpunkt herum können so zur Verbesserung der Genauigkeit des Ergebnisses genutzt werden, oder zur Bestimmung der Schwere des Fehlers, oder dergleichen. Grundsätzlich kann die kontinuierliche Speicherung in einem Ringspeicher die Verfügbarkeit von Daten unmittelbar vor dem Fehlerfall gewährleisten, was für eine weitergehende Auswertung interessant sein kann.

Die Berechnungseinheit berechnet den Ort eines Kurzschlusses aus dem bekannten Abstand bzw. den bekannten Abständen zwischen den Messeinrichtungen und einer Differenz zwischen den Werten der synchronisierte Zeitgeber, die für das erste Auftreten der Effekte des Kurzschlusses zwischen Leiter und elektrisch leitendem Schirm an der jeweiligen Messeinrichtung bestimmt oder ermittelt wurden, und gibt den berechneten Ort aus. Dazu wird die endliche Ausbreitungsgeschwindigkeit von Änderungen des Stroms in dem elektrisch leitenden Schirm genutzt, die u.a. von der Impedanz des Schirms abhängig ist. Wenn in ein langes Kabel bzw. dessen Schirm an einer beliebigen Stelle ein schnell auf einen hohen Wert ansteigender Strom eingeprägt wird, wird der Strom einen vergleichbaren Wert an einer weit von dem Einspeiseort entfernten Stelle erst mit einer von der Impedanz und der Entfernung abhängigen Verzögerung erreichen, u.a. weil der Strom zunächst die über die Länge des Kabels verteilte Kapazität zwischen Leiter und Schirm lädt. Die Steilheit zumindest eines Teils des Anstiegs des Stroms kann Aufgrund des Widerstands des elektrisch leitenden Schirms sowie der Induktivität der Leitung mit dem Abstand zu der Einspeisestelle abnehmen. Sofern an Verbindungsstellen von Segmenten des Kabels die Schirme mit Erde verbunden sind kann ein Teil des in dem Schirm fließenden Stroms dort abfließen, so dass in dem sich an die Verbindungsstelle anschließenden Segment des Kabels ein kleinerer Strom fließt. Bei Messungen des Stroms in den Erdungsleitungen ist außerdem zu berücksichtigen, dass diese stark abweichende Impedanzen im Vergleich zu der Impedanz des Schirms aufweisen können, so dass die Anstiegskurve des Stroms über die Zeit in der Erdungsleitung anders verlaufen kann als in dem elektrisch leitenden Schirm.

Entsprechend können der Berechnungseinheit bei einer oder mehreren Ausgestaltungen des Verfahrens die Impedanz des elektrisch leitenden Schirms und/oder der den elektrisch leitenden Schirm und Erde verbindenden Erdungsleitung repräsentierende Werte für die Berechnung des Orts zugeführt werden.

Bei einer oder mehreren Ausgestaltungen des Verfahrens werden die Zeitgeber der Messeinrichtungen mittels der Signale eines Satellitennavigationssystems, Synchronisierungssignalen eines Zeitzeichensenders für funkgesteuerte Uhren, bspw. DCF77, MSF, WWV, WWVB, WWVH, und/oder über eine die Messeinrichtungen verbindende Kommunikationsleitung gesendeter Synchronisierungssignale synchronisiert. Die Synchronisierung kann zyklisch in regelmäßigen Abständen erfolgen oder bedarfsweise. Bei der Synchronisierung mittels der Signale eines Zeitzeichensenders kann der bekannte Abstand zwischen der Sendeantenne und den jeweiligen Empfänger zur Korrektur der Laufzeit der Signale genutzt werden. Bei einer Synchronisierung über eine die Messeinrichtungen verbindende Kommunikationsleitung ist insbesondere bei der Verwendung von optischen Übertragungsmedien eine hohe Genauigkeit erreichbar; auch hier kann der bekannte Abstand zwischen den Messeinrichtungen und zu einer zentralen Kommunikationseinheit zur Korrektur der Laufzeit der Signale genutzt werden.

Eine Messeinrichtung gemäß dem zweiten Aspekt zur Erfassung eines in dem elektrisch leitenden Schirm eines Hochspannungskabels und/oder eines in einer den elektrisch leitenden Schirm und Erde verbindenden Erdungsleitung fließenden elektrischen Stroms umfasst eine Strommessvorrichtung zur Erfassung des Stroms in dem elektrisch leitenden Schirm und/oder in der Erdungsleitung. Die Strommessvorrichtung ist zweckmäßigerweise dazu eingerichtet, den Strom mit einer hohen Abtastrate zu erfassen, beispielsweise alle 0,5 µs oder in noch kürzeren Zeitabständen. Die Messeinrichtung umfasst außerdem einen Zeitgeber, der mit Zeitgebern anderer Messeinrichtungen synchronisierbar ist. Ferner umfasst die Messeinrichtung eine Kommunikationsschnittstelle, welche zur Übertragung von Messwerten an eine von mehreren Messeinrichtungen genutzte Analyseeinheit und/oder eine zentrale Berechnungseinheit eingerichtet ist.

Die Kommunikationsschnittstelle kann beispielsweise eine Glasfaserverbindung, eine drahtlose Kommunikationsverbindung oder eine Netzwerkverbindung umfassen, bei der elektrische Signale über entsprechende Leitungen gesendet werden. Die Kommunikationsschnittstelle kann auch dazu eingerichtet sein, Daten jeweils über eine benachbarte Messeinrichtung an die Analyseeinheit oder die Berechnungseinheit weiterzuleiten, so dass eine direkte Verbindung zu den letztlichen Empfängern der Daten nicht für alle Messeinrichtungen erforderlich ist.

Bei einer Ausführung umfasst die Messeinrichtung eine Analyseeinheit, so dass über die Kommunikationsschnittstelle lediglich der Wert des Zeitgebers für den Zeitpunkt an die zentrale Berechnungseinheit übertragen werden muss, für den das Auftreten eines Kurzschlusses festgestellt bzw. ermittelt wurde. Der Ort der Messung kann in der Berechnungseinheit hinterlegt sein und anhand der Sender-Identifikation ermittelt werden. Ist der Ort nicht hinterlegt, muss der Ort der Messung ebenfalls übertragen werden.

Die Messeinrichtung umfasst darüber hinaus einen oder mehrere Mikroprozessoren und diesem oder diesen zugeordneten flüchtigen und/oder nicht flüchtigen Speicher, sowie eine Energieversorgung.

Ein System gemäß dem dritten Aspekt zur Lokalisierung eines Kurzschlusses zwischen einem Leiter und einem diesen umgebenden elektrisch leitenden Schirm eines Hochspannungskabels umfasst zwei oder mehr in bekanntem Abstand voneinander bzw. den Enden des Hochspannungskabels an dem Hochspannungskabel angeordneter Messeinrichtungen gemäß dem zweiten Aspekt, welche miteinander synchronisierte Zeitgeber und eine Messvorrichtung zur Erfassung eines in dem elektrisch leitenden Schirm und/oder eines in einer den elektrisch leitenden Schirm und Erde verbindenden Erdungsleitung fließenden elektrischen Stroms aufweisen. Die Messeinrichtungen sind ferner dazu eingerichtet, Paare aus Strommesswerten und dazugehörigen Werten des Zeitgebers zyklisch für aneinander angrenzende Zeitabschnitte oder kontinuierlich an eine Analyseeinheit zu übertragen.

Bei einer Ausgestaltung des Systems ist den Messeinrichtungen eine entsprechende Analyseeinheit vorgesehen. Bei einer anderen Ausgestaltung des Systems ist eine Analyseeinheit für mehrere Messeinrichtungen vorgesehen. Bei wiederum einer anderen Ausgestaltung weisen einige Messeinrichtungen eine eigene Analyseeinheit auf, andere sind mit einer gemeinsam genutzten Analyseeinheit verbunden.

Jede Analyseeinheit ist dazu eingerichtet, die übertragenen Paare aus Strommesswerten und dazugehörigen Werten des Zeitgebers zu analysieren und bei Auftreten eines einen Schwellenwert überschreitenden Stroms oder eines bestimmte Vorgaben erfüllenden Stromverlaufs über die Zeit zumindest jeweils den zugehörigen Wert des Zeitgebers einer Berechnungseinheit des Systems zuzuführen, der dem Zeitpunkt entspricht, an dem erste Effekte des Kurzschlusses an dem Ort der Messung auftraten. Das Überschreiten eines Schwellenwerts für den gemessenen Strom bzw. ein bestimmter Stromverlauf über die Zeit kann bspw. als Indiz für einen Kurzschluss zwischen Leiter und elektrisch leitendem Schirm interpretiert werden, woraufhin die Analyseeinheit ggf. eine Korrekturrechnung vornimmt, um auch Stromverläufe unterhalb des Schwellenwerts zu untersuchen und daraus den Zeitpunkt zu ermitteln, an dem die Effekte des Kurzschlusses erstmals an dem Ort der Messung auftraten.

Die Berechnungseinheit ist dazu eingerichtet, aus dem bekannten Abstand zwischen den Messeinrichtungen und einer Differenz zwischen den zugeführten Werten der synchronisierten Zeitgeber den Ort des Kurzschlusses zu lokalisieren. Dazu wird die endliche Ausbreitungsgeschwindigkeit von Änderungen des Stroms in dem elektrisch leitenden Schirm genutzt, die u.a. von der Impedanz des Schirms abhängig ist. Außerdem können der Berechnungseinheit Informationen über die Orte und Impedanzen von entlang des Kabels angeordneten, den Schirm mit Erde verbindenden Erdungsleitungen als Eingangsinformationen für die Berechnung des Orts des Kurzschlusses zugeführt sein.

Eine Übertragungsstrecke für elektrische Energie hoher Spannung umfasst ein Hochspannungskabel, das einen elektrischen Leiter und einen diesen umgebenden elektrisch leitenden Schirm umfasst. An dem elektrisch leitenden Schirm sind in bekanntem Abstand voneinander zwei oder mehr Messeinrichtungen eines Systems nach dem dritten Aspekt angeordnet, welche dazu eingerichtet sind, einen Zeitpunkt zu ermitteln, an dem erste Effekte eines Kurzschlusses zwischen Leiter und elektrisch leitendem Schirm am Ort der Messeinrichtung auftraten. Die Messeinrichtungen sind mit einer Berechnungseinheit des Systems kommunikativ verbunden, die im Falle eines Kurzschlusses dessen Ort an dem Kabel bestimmt und ausgibt.

In einem weiteren Aspekt kann die Erfindung die Genauigkeit der einer Offline-Messung erhöhen, bei der nach Auftreten des Fehlers and nach Trennung der Kabelstrecke vom Netz Fremdspannungen und/oder Fremdströme zur Fehlerortung eingespeist werden. So wird z.B. bei einer Time-Domain-Reflektometrie (TDR) Messung an einem Kabelende ein Spannungsimpuls eingespeist, der sich als elektromagnetische Welle im Kabel ausbreitet. Dieser Impuls kann als Spannung zwischen Leiter und Schirm, aber auch als Strom im Leiter und Strom im Schirm erkannt werden. Im herkömmlichen Verfahren wird der Spannungsimpuls eingespeist, und am gleichen Ort der reflektierte Spannungsimpuls ausgewertet. Diese Messung unterliegt der Dämpfung des zweifachen Durchlaufs vom Einspeisepunkt zum Fehlerort. In Kombination mit dem erfindungsgemäßen Verfahren zur Lokalisierung eines Kurzschlusses zwischen einem Leiter und einem diesen umgebenden elektrisch leitenden Schirm und der entsprechenden Auswertung kann auch dieser Impuls in direkter Nähe zum Fehlerort in den Messeinrichtungen erkannt werden. Aufgrund der Nähe der Auswertung zum Fehlerort kann die Genauigkeit der TDR Messung gegenüber dem konventionellen Verfahren, bei dem eine Auswertung nur an der Einspeisestelle erfolgt, erhöht werden.

### Kurze Beschreibung der Zeichnung

Nachfolgend wird die Erfindung anhand einer Ausführungsform unter Bezugnahme auf die begleitenden Figuren exemplarisch näher erläutert. Alle Figuren sind rein schematisch und nicht maßstäblich. Es zeigen:
- Fig. 1: eine schematische Darstellung von Stromflüssen in einer aus mehreren Segmenten bestehenden Übertragungsstrecke für elektrische Energie mit einem Kurzschluss zwischen Leiter und elektrisch leitendem Schirm,
- Fig. 2: eine schematische Darstellung eines Ausschnitts einer Übertragungsstrecke für elektrische Energie mit im Abstand von 2 km angeordneten Verbindungsstellen und einem Kurzschluss zwischen dem Leiter und dem elektrisch leitenden Schirm,
- Fig. 3: a) - d) zeitliche Verläufe der Ströme in dem elektrisch leitenden Schirm an den Verbindungsstellen,
- Fig. 4: a) - d) zeitliche Verläufe der Ströme in den elektrisch leitenden Schirm und Erde verbindenden Erdungsleitungen an den Verbindungsstellen,
- Fig. 5: ein exemplarisches Flussdiagramm eines erfindungsgemäßen Verfahrens,
- Fig. 6: ein schematisches Blockschaltbild einer erfindungsgemäßen Messeinrichtung, und
- Fig. 7: ein schematisches Blockschaltbild eines erfindungsgemäßen Systems.

Gleiche oder ähnliche Elemente sind in den Figuren mit gleichen oder ähnlichen Bezugszeichen versehen.

### Ausführungsbeispiel

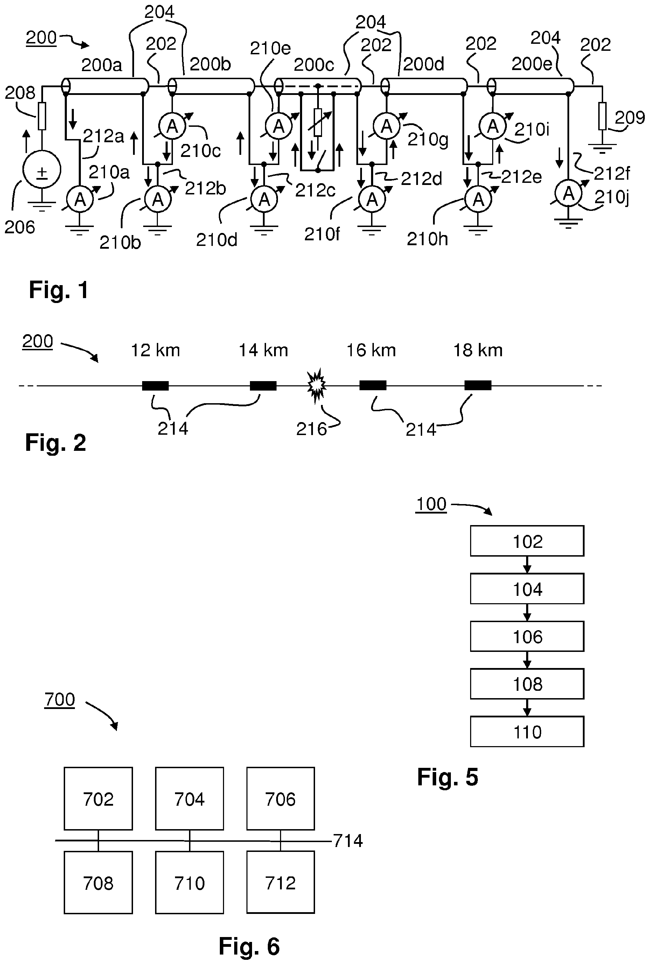

Figur 1 zeigt eine schematische Darstellung der Stromflüsse in den elektrisch leitenden Schirmen der Segmente und den die Schirme und Erde verbindenden Erdungsleitern in einer aus mehreren Segmenten 200a - 200e bestehenden Übertragungsstrecke 200 für elektrische Energie mit einem Kurzschluss zwischen Leiter 202 und elektrisch leitendem Schirm 204 in Segment 200c. In der Figur ist Übertragungsstrecke für die Übertragung von Gleichstrom genutzt, der von einer Gleichstromquelle 206 mit einem Innenwiderstand 208 eingespeist wird. Am anderen Ende der Übertragungsstrecke ist ein Lastwiderstand 209 angeordnet. Die Flussrichtung der Ströme ist durch die Pfeile angegeben. An den beiden Enden der Übertragungsstrecke 200 und an den Verbindungsstellen der Segmente sind Strommessgeräte 210a - 21 0j angeordnet, welche die Ströme in dem elektrisch leitenden Schirm 204 bzw. in den die Schirme 204 und Erde verbindenden Erdungsleitungen 212a - 212f messen. Die Abstände der Punkte an denen die Ströme gemessen werden sind wegen der bekannten Länge der Kabelsegmente ebenfalls bekannt.

Vor dem Kurzschluss flossen nur vernachlässigbar kleine Ströme in den Schirmen. Ab dem Augenblick des Kurzschlusses fließen vergleichsweise hohe Ströme durch die Schirme in den Segmenten, wobei die Ströme entsprechend der Impedanz des Schirms zu beiden Seiten des Kurzschlusses fließen. An jedem Erdungspunkt an einer Verbindungsstelle der Schirme kann ein Teil des Stroms gegen Erde abfließen, wobei die Größe des gegen Erde abfließenden Stroms von der Impedanz der Erdungsleitung abhängig ist. In der Regel sind die Erdungsleitungen nicht dazu ausgelegt, einen Strom in der Größenordnung des Nennstroms gegen Erde abzuleiten, weil im Normalfall nur vergleichsweise kleine Ströme in dem Schirm fließen. Daher kann es vorkommen, dass der Großteil des Kurzschlussstroms erst an den beiden Enden der Übertragungsstrecke gegen Erde abfließen kann.

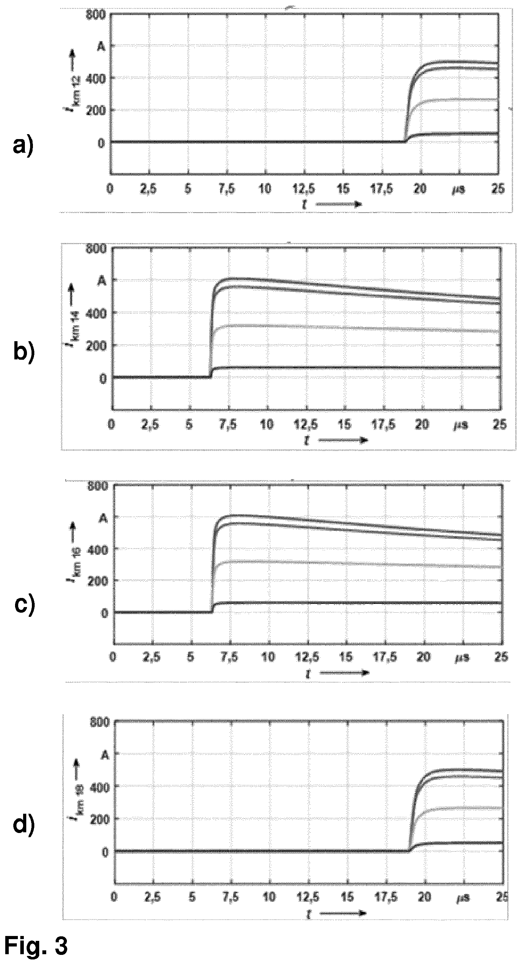

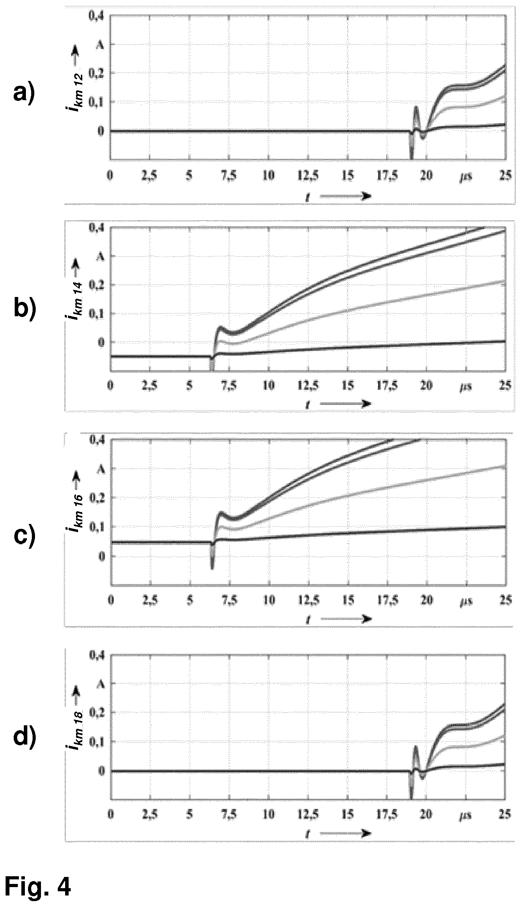

Figur 2 zeigt eine schematische Darstellung eines Ausschnitts einer Übertragungsstrecke 200 für elektrische Energie mit im Abstand von 2 km angeordneten Verbindungsstellen 214 von Kabelsegmenten und einem Kurzschluss 216 zwischen dem Leiter und dem elektrisch leitenden Schirm (in der Figur nicht separat dargestellt). Der Ausschnitt zeigt den Bereich zwischen km 12 und km 18 der Übertragungsstrecke, und der Kurzschluss 216 liegt bei km 15. Für die exemplarische Übertragungsstrecke 200 werden in den nachfolgenden Figuren 3 und 4 die in einer Simulation berechneten Ströme im Schirm und in den Erdleitungen unmittelbar vor und nach dem Kurzschluss 2016 dargestellt. Dabei wird angenommen, dass die Strecke 30 km lang ist, der Kurzschluss 216 also genau in der Mitte der Übertragungsstrecke 200 liegt, und die Impedanzen der Schirme und der Erdungsleitungen zu beiden Seiten des Kurzschlusses 216 gleich sind.

Figur 3 zeigt die Stromverläufe über die Zeit in den Schirmen an, die für an den bei km 12, km 14, km 16 und km 18 liegenden Verbindungsstellen 214 angeordnete Messeinrichtungen berechnet sind. In den Figuren 3 a) - 3 d) sind exemplarische Stromverläufe für Kurzschlüsse mit Impedanzen von 0 Ohm, 1 Ohm, 10 Ohm und 100 Ohm angegeben, die sich in unterschiedlichen Amplituden der Ströme niederschlagen.

In Figur 3 a) ist der Betrag des Stroms bei km 12 über die Zeit aufgetragen, wobei die Zeitmessung mit 0 zum Zeitpunkt des Kurzschlusses beginnt. Entsprechend sind in den Figuren 3 b) - 3 d) die Beträge der Ströme über die Zeit bei km 14, km 16 und km 18 aufgetragen. Es ist leicht erkennbar, dass der Anstieg des Stroms an den jeweiligen Messeinrichtungen mit einer gewissen Verzögerung gegenüber dem Zeitpunkt des Kurzschlusses erfolgt. Bei der Simulation liegt der Kurzschluss genau in der Mitte der von ihren Impedanzen homogenen Übertragungsstrecke, so dass die Zeitpunkte der Anstiege zu beiden Seiten des Kurzschlusses jeweils gleich sind. Der Anstieg bei den beiden jeweils in 1 km Entfernung, also dem Kurzschluss am nächsten liegenden Messeinrichtungen erfolgt etwa 6,4 µs nach dem Kurzschluss, während der Anstieg bei den jeweils 3 km entfernt liegenden Messeinrichtungen etwa 19 µs nach dem Kurzschluss erfolgt. Die zeitliche Verzögerung wird durch die Impedanz des elektrisch leitenden Schirms bestimmt, welche u.a. von der Anordnung, den Abmessungen und den elektrischen Eigenschaften der Materialien beeinflusst wird. Aus dem zeitlichen Versatz des Anstiegs der Ströme in dem Schirm an unterschiedlichen Stellen, dem bekannten Abstand der Messeinrichtungen voneinander und der bekannten Impedanz kann daraus der Ort des Kurzschlusses bestimmt werden.

Bei der Erkennung eines Kurzschlusses kann ein Anstieg des Stromes über einen Schwellenwert genutzt werden, ein typischer Verlauf des Stroms über die Zeit, oder eine Kombination aus beiden. Insbesondere bei vergleichsweise hochohmigen Kurzschlüssen, wie bspw. einem Kurzschluss mit einer Impedanz von 100 Ohm, welcher durch die jeweils unterste Kurve in den Figuren dargestellt ist, kann die sich ändernde Steigung des Stroms ausgehend von der Nulllinie als Merkmal für die Erkennung eines Kurzschlusses genutzt werden. Kurvenverläufe können als Vergleichsmuster für eine Vielzahl von Kurzschluss-Impedanzen bereitgestellt werden, oder in einem oder mehreren analytischen Ausdrücken. Dabei ist leicht ersichtlich, dass eine hohe Abtastrate bei der Erfassung der Ströme für eine hohe Genauigkeit der Bestimmung des Orts des Kurzschlusses von Vorteil ist.

Figur 4 zeigt zeitliche Verläufe der Ströme in den elektrisch leitenden Schirm und Erde verbindenden Erdungsleitungen an den Verbindungsstellen. Wie in Figur 3 sind jeweils zwei Messeinrichtungen im Anstand von 1 km vom Kurzschluss angeordnet, und zwei jeweils im Abstand von 3 km. Der zeitliche Versatz ist entsprechend identisch. In Figur 4 a) - 4 d) ist auffällig, dass die Ströme in den Erdungsleitungen erheblich kleiner sind als die Ströme im Schirm, was vor allem von den Impedanzen der Erdleitungen abhängig ist. Auch ist die Form des Anstiegs der Ströme unterschiedlich, so dass hier ggf. andere Verfahren zur Erkennung eines Kurzschlusses genutzt werden als bei der Überwachung des Stroms durch den Schirm. Interessant ist hierbei, dass in dem Moment, in dem der Kurzschluss an der jeweiligen Messeinrichtung erkennbar wird, zunächst ein Strom von Erde in den Schirm fließt, was mit Ausgleichsvorgängen erklärt werden kann. Dieser "negative" Stromfluss kann bspw. als Indiz für einen Kurzschluss herangezogen werden. Ein Vergleich der Verläufe der Ströme über die Zeit wird aber auch an dieser Stelle hinreichend genaue Ergebnisse liefern. Die Bestimmung des Orts des Kurzschlusses erfolgt in gleicher Weise wie mit Bezug auf Figur 3 angesprochen.

Um die Erkennung möglichst zuverlässig zu gestalten kann in jeder Messeinrichtung der Strom in der Erdungsleitung und der Strom in dem Schirm erfasst werden. Die Überwachung nur eines der beiden Ströme kann, abhängig von den Eigenschaften der Kabel und der Erdungsleitung ausreichend genaue Ergebnisse liefern.

Figur 5 zeigt ein schematisches Flussdiagramm eines erfindungsgemäßen Verfahrens 100 zur Lokalisierung eines Kurzschlusses zwischen einem Leiter und einem diesen umgebenden elektrisch leitenden Schirm eines Hochspannungskabels. In Schritt 102 werden mindestens zwei jeweils in bekanntem Abstand voneinander bzw. von den Enden des Hochspannungskabels an dem Hochspannungskabel angeordnete Messeinrichtungen bereitgestellt, welche miteinander synchronisierte Zeitgeber und eine Messvorrichtung zur Erfassung eines in dem elektrisch leitenden Schirm und/oder eines in einer den elektrisch leitenden Schirm und Erde verbindenden Erdungsleitung fließenden elektrischen Stroms aufweisen. In Schritt 104 werden Paare aus Strommesswerten und dazugehörigen Werten des Zeitgebers zyklisch für aneinander angrenzende Zeitabschnitte oder kontinuierlich von den Messvorrichtungen an eine Analyseeinheit übertragen. Eine Analyseeinheit kann in jeder Messeinrichtung vorhanden sein, oder mehrere Messeinrichtungen können eine Analyseeinheit gemeinsam nutzen.

Eine kontinuierliche Übertragung an die Analyseeinheit setzt eine ausreichend schnelle Datenverbindung voraus. Daher kann diese Variante vorzugsweise in einer Ausführungsform genutzt werden, in der die Analyseeinheit Teil der Messeinrichtung ist, sodass schnelle interne Verbindungen zwischen der Messvorrichtung und der Analyseeinheit genutzt werden können. Eine zyklische Übertragung von Paaren von Strommesswerten und dazugehörigen Werten des Zeitgebers kann vorteilhaft sein, wenn die Analyseeinheit nicht Teil der Messeinrichtung ist, sondern von mehreren Messeinrichtungen gemeinsam genutzt wird. Zumindest für die zyklische Übertragung können die Paare von Strommesswerten und dazugehörigen Werte des Zeitgebers zwischengespeichert werden, bevor sie gesammelt an die Analyseeinheit übertragen werden. Um die zu übertragene Datenmenge klein zu halten können Datenkompressionsverfahren genutzt werden. In der Analyseeinheit können die zyklisch empfangenen Daten wieder zu einer kontinuierlichen Messreihe zusammengesetzt werden, welche dann analysiert wird.

In Schritt 106 führt die Analyseeinheit einer Berechnungseinheit bei Auftreten eines einen Schwellenwert überschreitenden Stroms und/oder eines bestimmte Vorgaben erfüllenden Stromverlaufs über die Zeit zumindest jeweils des zugehörigen Wertes des Zeitgebers oder der zugehörigen Werte der Zeitgeber zu, sowie eine Angabe über den Ort der Messung. Der Wert bzw. die Werte des Zeitgebers beschreibt bzw. beschreiben den Zeitpunkt, an dem sich der Stromverlauf über die Zeit in dem Schirm so verändert, dass auf das Vorliegen eines Kurzschlusses zwischen dem Leiter und dem Schirm geschlossen werden kann.

In Schritt 108 berechnet die Berechnungseinheit aus dem bekannten Abstand zwischen den Messeinrichtungen und einer Differenz zwischen den Werten der synchronisierten Zeitgeber den Ort des Kurzschlusses, und gibt ihn in Schritt 110 aus.

Figur 6 zeigt ein schematisches Blockschaltbild einer erfindungsgemäßen Messeinrichtung 700 zur Erfassung eines in dem elektrisch leitenden Schirm eines Hochspannungskabels und/oder eines in einer den elektrisch leitenden Schirm und Erde verbindenden Erdungsleitung fließenden elektrischen Stroms. Die Messeinrichtung umfasst eine Strommessvorrichtung 702 zur Erfassung des Stroms in dem elektrisch leitenden Schirm und/oder in der Erdungsleitung und einen Zeitgeber 704, der mit entsprechenden Zeitgebern anderer Messeinrichtungen 700 synchronisierbar ist. Die Messeinrichtung umfasst außerdem eine Kommunikationsschnittstelle 706, die zur Übertragung von Paaren aus Messwerten der Strommessvorrichtung 702 und des Zeitgebers 704 an eine von mehreren Messeinrichtungen 700 genutzte Analyseeinheit 708' eingerichtet ist und/oder die zur Übertragung zumindest eines von einer in der Messeinheit 700 angeordneten Analyseeinheit 708 ermittelten Werts des Zeitgebers an eine zentrale Berechnungseinheit eingerichtet ist, der einem Zeitpunkt entspricht, an dem ein durch einen Kurzschluss zwischen Leiter und elektrisch leitendem Schirm hervorgerufener Strom in dem Schirm oder in der Erdungsleitung an dem Ort der Messeinheit 700 floss. Die Messeinrichtung umfasst ferner einen oder mehrere Mikroprozessoren 710 und diesem oder diesen zugeordneten flüchtigen und/oder nichtflüchtigen Speicher 712. Der nichtflüchtige Speicher kann Computerprogramminstruktionen enthalten, deren Ausführung durch den Mikroprozessor die Ausführung des erfindungsgemäßen Verfahrens oder von Teilen des Verfahrens bewirkt. Die Elemente der Messeinrichtung 700 können durch einen oder mehrere Kommunikationsleitungen oder -busse 714 miteinander verbunden sein.

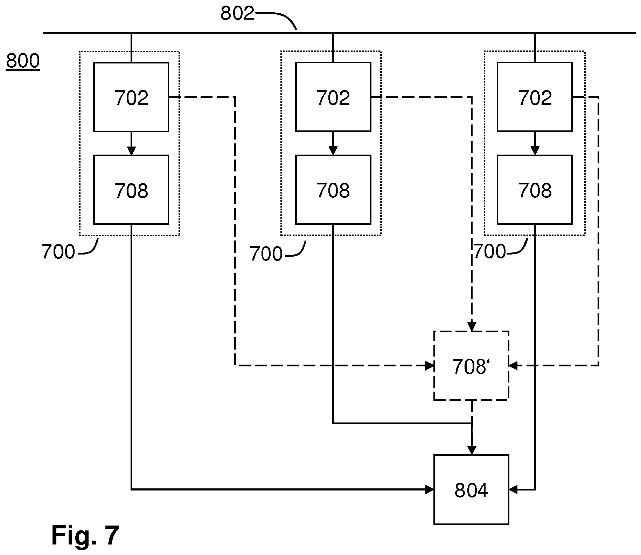

Figur 7 zeigt ein schematisches Blockschaltbild eines erfindungsgemäßen Systems 800 mit mehreren entlang eines Hochspannungskabels 802 angeordneten Messeinrichtungen 700. Die Messeinrichtungen 700 weisen eine Strommessvorrichtung 702 auf und können eine Analyseeinheit 708 aufweisen. Andere Elemente der Messeinrichtung 700 sind aus Gründen der Übersichtlichkeit nicht dargestellt. Die Analyseeinheiten 708 der Messeinrichtungen 700 sind mit einer zentralen Berechnungseinheit 804 kommunikativ verbunden.

Wenn in den Messeinrichtungen 700 keine eigenen Analyseeinheiten 708 vorgesehen sind, können die Messeinrichtungen 702 die erfassten Strommesswerte und die zugehörigen Messzeitpunkte auch an eine gemeinsam genutzte Analyseeinheit 708` senden, welche mit der Berechnungseinheit 804 kommunikativ verbunden ist. Die optionale Nutzung einer Analyseeinheit 708` durch mehrere Messeinrichtungen 700 ist in der Figur durch die gestrichelten Linien angedeutet.

### Bezuaszeichenliste

- 100: Verfahren
- 102-110: Verfahrensschritte
- 200: Übertragungsstrecke
- 200a-e: Segmente
- 202: Leiter
- 204: Schirm
- 206: Gleichstromquelle
- 208: Innenwiderstand
- 209: Lastwiderstand
- 210a-j: Strommessgerät
- 212a-f: Erdungsleitungen
- 700: Messeinrichtung
- 702: Strommessvorrichtung
- 704: Zeitgeber
- 706: Kommunikationsschnittstelle
- 708: Analyseeinheit
- 710: Mikroprozessor
- 712: Speicher
- 714: Kommunikationsleitung/-bus
- 800: System
- 802: Hochspannungskabel
- 804: Berechnungseinheit

## Patentansprüche

1. Verfahren (100) zur Lokalisierung eines Kurzschlusses zwischen einem Leiter und einem diesen umgebenden elektrisch leitenden Schirm einer zwei oder mehr in Reihe geschaltete Kabelsegmente umfassenden Hochspannungs-Gleichstromübertragungsstrecke (200) während des Betriebs der Hochspannungs-Gleichstromübertragungsstrecke (200), umfassend:
- Bereitstellen (102) von Messeinrichtungen (21 0a, 21 0j) an den Enden der Hochspannungs-Gleichstromübertragungsstrecke (200) zur kontinuierlichen Erfassung eines in einer den elektrisch leitenden Schirm und Erde verbindenden Erdungsleitung (212a, 212f) fließenden elektrischen Stroms, mindestens einer Messeinrichtung (210b, 210d, 210f, 210h) an einer Verbindung von Segmenten der Hochspannungs-Gleichstromübertragungsstrecke (200) zur kontinuierlichen Erfassung eines in einer den elektrisch leitenden Schirm und Erde verbindenden Erdungsleitung (212b, 212c, 212d, 212e) fließenden elektrischen Stroms, und mindestens einer Messeinrichtung (210c, 210e, 210g, 210i) an einer Verbindung von Segmenten der Hochspannungs-Gleichstromübertragungsstrecke zur kontinuierlichen Erfassung eines in dem elektrisch leitenden Schirm fließenden Stroms, wobei die Messeinrichtungen miteinander synchronisierte Zeitgeber aufweisen und zur Erfassung der Ströme mit einer hohen Abtastrate eingerichtet sind,
- Übertragen (104), zyklisch für aneinander angrenzende Zeitabschnitte oder kontinuierlich, von Paaren aus Strommesswerten und dazugehörigen Werten des Zeitgebers, die eine kontinuierliche Messreihe bilden, von den Messvorrichtungen an eine Analyseeinheit,
- Zuführen (106), von der Analyseeinheit zu einer Berechnungseinheit, bei Auftreten eines bestimmte Vorgaben erfüllenden Stromverlaufs über die Zeit, zumindest jeweils des zugehörigen Wertes des Zeitgebers oder der zugehörigen Werte der Zeitgeber sowie eine Angabe über den Ort der Messung, für den bzw. die erste Effekte des Kurzschlusses an dem Ort der Messung auftraten, wobei die Analyseeinheit dazu eingerichtet ist, den Stromverlauf vor und nach dem Kurzschluss zu analysieren, um den Zeitpunkt des ersten Auftretens von Effekten des Kurzschlusses am Messort zu bestimmen,
- Berechnen (108), in der Berechnungseinheit, des Orts eines Kurzschlusses aus dem bekannten Abstand zwischen den Messeinrichtungen und einer Differenz zwischen den Werten der synchronisierten Zeitgeber,
- Ausgeben (110) des berechneten Orts.

2. Verfahren (100) nach Anspruch 1, außerdem umfassend:
- Vergleichen, in der Analyseeinheit, eines Stromverlaufs über die Zeit mit einer Vielzahl von lokal gespeicherten Referenz-Stromverläufen über die Zeit, und
- Ableiten eines Zeitpunkts des Auftretens der ersten Effekte eines Kurzschlusses an dem Ort der Messung.

3. Verfahren (100) nach Anspruch 1 oder 2, außerdem umfassend:
- Zuführen von die Impedanz des elektrisch leitenden Schirms und/oder der Impedanz der den elektrisch leitenden Schirm und Erde verbindenden Erdungsleitung für jede Messeinrichtung repräsentierenden Werten zu der Berechnungseinheit für das Berechnen (108) des Orts.

4. Verfahren (100) nach einem der Ansprüche 1 - 3, außerdem umfassend:
- Synchronisieren der Zeitgeber der Messeinrichtungen mittels der Signale eines Satellitennavigationssystems, eines Zeitzeichensenders für funkgesteuerte Uhren und/oder über eine die Messstellen verbindende Kommunikationsleitung gesendeten Synchronisierungssignale.

5. System (800) zur Lokalisierung eines Kurzschlusses zwischen einem Leiter und einem diesen umgebenden elektrisch leitenden Schirm einer zwei oder mehr in Reihe geschaltete Kabelsegmente umfassenden Hochspannungs-Gleichstromübertragungsstrecke (802) während des Betriebs, umfassend:
- zwei Messeinrichtungen (700) an den Enden der Hochspannungs-Gleichstromübertragungsstrecke (802) zur kontinuierlichen Erfassung eines in einer den elektrisch leitenden Schirm und Erde verbindenden Erdungsleitung fließenden elektrischen Stroms, mindestens einer Messeinrichtung (700) an einer Verbindung von Segmenten der Hochspannungs-Gleichstromübertragungsstrecke (802) zur kontinuierlichen Erfassung eines in einer den elektrisch leitenden Schirm und Erde verbindenden Erdungsleitung fließenden elektrischen Stroms, und mindestens einer Messeinrichtung (700) an einer Verbindung von Segmenten der Hochspannungs-Gleichstromübertragungsstrecke zur kontinuierlichen Erfassung eines in dem elektrisch leitenden Schirm fließenden Stroms, wobei die Messeinrichtungen (700) dazu eingerichtet sind, Ströme mit einer hohen Abtastrate zu erfassen, wobei die Messeinrichtungen (700) miteinander synchronisierte Zeitgeber aufweisen und dazu eingerichtet sind, Paare aus Strommesswerten und dazugehörigen Werten des Zeitgebers zyklisch für aneinander angrenzende Zeitabschnitte oder kontinuierlich an eine Analyseeinheit (708, 708') zu übertragen,
- mindestens eine Analyseeinheit (708, 708'), welche dazu eingerichtet ist anhand der übertragenen Paare aus Strommesswerten und dazugehörigen Werten des Zeitgebers, die eine kontinuierliche Messreihe bilden, den Stromverlauf vor und nach einem Kurzschluss zu analysieren, um einen Zeitpunkt zu ermitteln, an dem erste Effekte des Kurzschlusses an der jeweiligen Messeinrichtung (700) auftraten, und jeweils den ermittelten Zeitpunkt einer Berechnungseinheit zuzuführen,
- eine Berechnungseinheit (804), die dazu eingerichtet ist, aus dem bekannten Abstand zwischen den Messeinrichtungen (700) und einer Differenz zwischen den zugeführten Zeitpunkten den Ort des Kurzschlusses zu lokalisieren.

6. System nach Anspruch 5, wobei die Berechnungseinheit (804) dazu eingerichtet ist, die Impedanz des Kabelschirms und/oder den elektrisch leitenden Schirm und Erde verbindender Erdungsleitungen sowie deren jeweiligen Ort entlang des Kabels der Berechnung zugrundezulegen.

7. Übertragungsstrecke für elektrische Energie hoher Spannung mit einem Hochspannungskabel 802, das einen elektrischen Leiter und einen den elektrischen Leiter umgebenden elektrisch leitenden Schirm umfasst und einem System (800) zur Lokalisierung eines Kurzschlusses zwischen dem Leiter und dem elektrisch leitenden Schirm nach Anspruch 5 oder 6.

## Claims

1. A method (100) for locating a short circuit between a conductor and an electrically conductive screen surrounding said conductor of a high-voltage direct current transmission line (200) comprising two or more cable segments connected in series during the operation of the high-voltage direct current transmission line (200), comprising:
- Providing (102) measuring devices (210a, 210j) at the ends of the high-voltage direct current transmission line (200) for the continuous detection of an electrical current flowing in a ground line (212a, 212f) connecting the electrically conductive screen and ground, at least one measuring device (210b, 210d, 210f, 210h) at a connection of segments of the high-voltage direct current transmission line (200) for the continuous detection of an electrical current flowing in a ground line (212b, 212c, 212d, 212e) connecting the electrically conductive screen and ground, and at least one measuring device (210c, 210e, 210g, 210i) at a connection of segments of the high-voltage direct current transmission line for the continuous detection of a current flowing in an electrically conductive screen, wherein the measuring devices have timers synchronized with one another and are set up to detect the currents at a high sampling rate,
- transmitting (104), cyclically for contiguous periods of time or continuously, pairs of current measurement values and associated values of the timer, which form a continuous measurement series from the measurement devices to an analysis unit,
- supplying (106), from the analysis unit to a calculation unit, when a current course meeting certain specifications occurs over time, at least the associated value of the timer or the associated values of the timers as well as an indication of the location of the measurement for which the first effect of the short circuit occurred at the location of the measurement, wherein the analysis unit is set up to analyze the current course before and after the short circuit, in order to determine the point in time of the first occurrence of effects of the short circuit at the location of the measurement,
- calculating (108), in the calculation unit, the location of a short circuit from the known distance between the measuring devices and a difference between the values of the synchronized timers,
- outputting (110) the calculated location.

2. The method (100) according to claim 1, furthermore comprising:
- Comparing, in the analysis unit, a current course over time with a plurality of locally stored reference current courses over time, and
- deriving a point in time of the occurrence of the first effects of a short circuit at the location of the measurement.

3. The method (100) according to claim 1 or 2, furthermore comprising:
- Supplying values representing the impedance of the electrically conductive screen and/or the impedance of the ground line connecting the electrically conductive screen and ground for each measuring device to the calculation device for the calculation (108) of the location.

4. The method (100) according to any one of claims 1 - 3, furthermore comprising:
- Synchronizing the timers of the measuring devices by means of the signals of a satellite navigation system, a time signal transmitter for radio-controlled clocks and/or synchronization signals transmitted via a communication line connecting the measuring points.

5. A system (800) for locating a short circuit between a conductor and an electrically conductive screen surrounding said conductor of a high-voltage direct current transmission line (802) comprising two or more cable segments connected in series during the operation, comprising:
- two measuring devices (700) at the ends of the high-voltage direct current transmission line (802) for the continuous detection of an electrical current flowing in a ground line connecting the electrically conductive screen and ground, at least one measuring device (700) at a connection of segments of the high-voltage direct current transmission line (802) for the continuous detection of an electrical current flowing in a ground line connecting the electrically conductive screen and ground, and at least one measuring device (700) at a connection of segments of the high-voltage direct current transmission line for the continuous detection of a current flowing in the electrically conductive screen, wherein the measuring devices (700) are set up to detect currents at a high sampling rate, wherein the measuring devices (700) have timers synchronized with one another and are set up pairs of current measurement values and associated values of the timer cyclically for contiguous periods of time or continuously to an analysis unit (708, 708'),
- at least one analysis unit (708, 708'), which is set up using the transmitted pairs of current measurement values and associated values of the timer, which form a continuous measurement series, to analyze the current course before and after a short circuit, in order to determine the point time at which first effects of the short circuit occurred at the respective measuring device (700), and in each case to supply the determined point in time to a calculation unit,
- a calculation unit (804), which is set up to locate the location of the short circuit from the known distance between the measuring devices (700) and a difference between the points in time supplied.

6. The system according to claim 5, wherein the calculation unit (804) is set up to be used as the basis for calculating the impedance of the cable screen and/or the ground lines connecting the electrically conductive screen and ground as well as their respective location along the cable.

7. A transmission line for high-voltage electrical energy having a high-voltage cable (802), which comprises an electrical conductor and an electrically conductive screen surrounding the electrical conductor and having a system (800) for locating a short circuit between the conductor and the electrically conductive screen according to claim 5 or 6.

## Revendications

1. Procédé (100) de localisation d'un court-circuit entre un conducteur et un blindage électroconducteur, entourant celui-ci, d'un circuit de transmission de courant continu haute tension (200) comprenant deux segments de câble montés en série ou davantage pendant le fonctionnement du circuit de transmission de courant continu haute tension (200), comprenant :
- la fourniture (102) de dispositifs de mesure (210a, 210j) aux extrémités du circuit de transmission de courant continu haute tension (200) pour la détection continue d'un courant électrique s'écoulant dans une ligne de mise à la terre (212a, 212f) raccordant le blindage électroconducteur et la terre, d'au moins un dispositif de mesure (210b, 210d, 210f, 210h) sur un raccordement de segments du circuit de transmission de courant continu haute tension (200) pour la détection continue d'un courant électrique s'écoulant dans une ligne de mise à la terre (212b, 212c, 212d, 212e) raccordant le blindage électroconducteur et la terre, et d'au moins un dispositif de mesure (210c, 210e, 210g, 210i) sur un raccordement de segments du circuit de transmission de courant continu haute tension pour la détection continue d'un courant s'écoulant dans le blindage électroconducteur, les dispositifs de mesure présentant des minuteurs synchronisés entre eux et étant agencés pour la détection des courants avec une fréquence d'échantillonnage élevée,
- la transmission (104), cyclique pour des segments de temps adjacents ou continue, depuis les dispositifs de mesure vers une unité d'analyse, de paires de valeurs de mesure de courant et de valeurs connexes du minuteur qui forment une série de mesures continue,
- l'acheminement (106), depuis l'unité d'analyse vers une unité de calcul, lors de l'apparition d'une allure du courant dans le temps répondant à des prescriptions définies, d'au moins respectivement la valeur connexe du minuteur ou des valeurs connexes des minuteurs ainsi qu'une indication sur l'emplacement de la mesure pour laquelle ou respectivement lesquelles les premiers effets du court-circuit sont apparus à l'emplacement de la mesure, l'unité d'analyse étant agencée pour analyser l'allure du courant avant et après le court-circuit afin de déterminer le moment de la première apparition d'effets du court-circuit à l'emplacement de mesure,
- le calcul (108), dans l'unité de calcul, de l'emplacement d'un court-circuit à partir de la distance connue entre les dispositifs de mesure et d'une différence entre les valeurs des minuteurs synchronisés,
- la délivrance (110) de l'emplacement calculé.

2. Procédé (100) selon la revendication 1, comprenant en outre :
- la comparaison, dans l'unité d'analyse, d'une allure du courant dans le temps avec une multiplicité d'allures du courant de référence dans le temps enregistrées localement, et
- la dérivation d'un moment de l'apparition des premiers effets d'un court-circuit à l'emplacement de la mesure.

3. Procédé (100) selon la revendication 1 ou 2, comprenant en outre :
- l'acheminement vers l'unité de calcul, pour le calcul (108) de l'emplacement, de valeurs représentant l'impédance du blindage électroconducteur et/ou de l'impédance de la ligne de mise à la terre raccordant le blindage électroconducteur et la terre pour chaque dispositif de mesure.

4. Procédé (100) selon l'une des revendications 1 à 3, comprenant en outre :
- la synchronisation des minuteurs des dispositifs de mesure au moyen des signaux d'un système de navigation par satellite, d'un émetteur de signaux horaires pour des horloges commandées par radio et/ou de signaux de synchronisation émis par le biais d'une ligne de communication raccordant les points de mesure.

5. Système (800) de localisation d'un court-circuit entre un conducteur et un blindage électroconducteur, entourant celui-ci, d'un circuit de transmission de courant continu haute tension (802) comprenant deux segments de câble montés en série ou davantage pendant le fonctionnement, comprenant :
- deux dispositifs de mesure (700) aux extrémités du circuit de transmission de courant continu haute tension (802) pour la détection continue d'un courant électrique s'écoulant dans une ligne de mise à la terre raccordant le blindage électroconducteur et la terre, d'au moins un dispositif de mesure (700) sur un raccordement de segments du circuit de transmission de courant continu haute tension (802) pour la détection continue d'un courant électrique s'écoulant dans une ligne de mise à la terre raccordant le blindage électroconducteur et la terre, et d'au moins un dispositif de mesure (700) sur un raccordement de segments du circuit de transmission de courant continu haute tension pour la détection continue d'un courant s'écoulant dans le blindage électroconducteur, les dispositifs de mesure (700) étant agencés pour détecter des courants avec une fréquence d'échantillonnage élevée, les dispositifs de mesure (700) présentant des minuteurs synchronisés entre eux et étant agencés pour transmettre à une unité d'analyse (708, 708') des paires de valeurs de mesure de courant et de valeurs connexes du minuteur de façon cyclique pour des segments de temps adjacents ou de de façon continue,
- au moins une unité d'analyse (708, 708') qui est agencée pour, à l'aide des paires transmises de valeurs de mesure de courant et de valeurs connexes du minuteur qui forment une série de mesures continue, analyser l'allure du courant avant et après un court-circuit afin de déterminer un moment auquel des premiers effets du court-circuit sont apparus sur le dispositif de mesure (700) respectif et afin d'acheminer à une unité de calcul respectivement le moment déterminé,
- une unité de calcul (804) qui est agencée pour localiser l'emplacement du court-circuit à partir de la distance connue entre les dispositifs de mesure (700) et d'une différence entre les moments acheminés.

6. Système selon la revendication 5, l'unité de calcul (804) étant agencée pour prendre pour base du calcul l'impédance de blindage de câble et/ou des lignes de mise à la terre raccordant le blindage électroconducteur et la terre ainsi que leur emplacement respectif le long du câble.

7. Circuit de transmission pour une énergie électrique de haute tension avec un câble haute tension (802) qui comprend un conducteur électrique et un blindage électroconducteur entourant le conducteur électrique, et avec un système (800) de localisation d'un court-circuit entre le conducteur et le blindage électroconducteur selon la revendication 5 ou 6.
